# EUROPEAN PATENT SPECIFICATION

(11) **EP 4 513 161 B1**
(45) Date of publication and mention of the grant of the patent: **02.07.2025**
(21) Application number: 24191725.1
(22) Date of filing: 30.07.2024
(51) Int. Cl.: G01M 15/02

(54) **PROBE**
SONDE
SONDE

(30) Priority: 25.08.2023 GB 202312987
(43) Date of publication of application: 26.02.2025
(73) Proprietor: Rolls-Royce plc, London N1 9FX (GB)
(72) Inventor: Dong, Xin, Derby, DE24 8BJ (GB); Liu, Jing, Derby, DE24 8BJ (GB); Axinte, Dragos, Derby, DE24 8BJ (GB); Norton, Andrew, Derby, DE24 8BJ (GB)
(74) Representative: Rolls-Royce plc

(56) References cited:
- US-A- 5 546 008
- US-B1- 6 225 813

## Description

### FIELD

The present invention relates to an inflatable probe for testing a component. In particular, the invention relates to an inflatable probe in the form of a dielectric elastomer balloon that is able to be deformed to position itself within a complex system with confined spaces, e.g. within electrical equipment such as an electrical motor.

### BACKGROUND

Complex systems are used in a number of areas of technology. They are complex in that they include both moving and static parts. In power generation, complex systems include turbines and engines. Electrical equipment is being more commonly used in power generation systems. Part of the reason for this is that engineers are looking for ways of reducing emissions of carbon dioxide; this is especially true in propulsion systems where fossil fuel-based combustion engines are being replaced with electrical motors connected to battery packs.

Electrical power for vehicular systems is seen to be a greater part of future designs as the technology develops. However, one of the issues with using electrical power, rather than the combustion of fossil fuels, is that electrical power requires new methods to test, probe and repair electrical motors. This is because gaps between components in electrical motors tend to be much smaller than they are in combustion engines. Furthermore, many other systems, such as nuclear power, oil and gas production and telecoms systems have complex systems that are located within confined spaces. Consequently, the requirements for in situ repairs are much more complex as the classical tools that have been used for testing and repairing older systems are often not suitable for these complex systems.

In the electrical field for example, one area in which there can be problems is in the detecting, monitoring and repairing of faults on or near a rotor or a stator. Conventional borescope and robotic inspection devices are often too large to fit in the gaps between components.

United States patent US 6225813 B1 discloses a portable capacitance mapping tool for in situ field stator bar insulation capacitance mapping. The capacitance mapping tool consists of an improved capacitance probe head assembly that has an inflatable electrode bladder mounted at the end of a telescoping support pole that is provided for enabling a service technician to accurately position the probe head assembly between stator bars of a large electric motor or power generator from a remote location. Using the tool, capacitance measurements of insulation on stator bars can be obtained without removing the field. The tool is constructed such that it can be inserted between the field generating component (e.g., the rotor) and the stator windings of a large motor or power generator, thus, precluding the need for field removal. A bendable articulated tip section, which remains in a particular bend arrangement until manually reconfigured, is provided at one end of the tool where the capacitance measuring probe head is attached. This allows the probe head to be, preconfigured at a particular angle with respect to the support pole and the stator bars prior to inserting. The probe head includes a bladder support plate which acts as a spacer and is adapted to accept one or more additional spacer plates for changing the overall width of the probe head to adjust for different spacings between stator bars. The pole supports an electric cable from the probe electrode to a remote electric meter and an air hose to a remote fluid source for inflating/deflating the probe bladder.

United States patent US 5546008 discloses an inflatable capacitance test device for measuring the capacitance of the insulation wrap on armature bars in electromagnetic generators and motors. The test device has a probe that has an electrode plate mounted on an inflatable bladder. The plate is formed of an elastomeric conductive material and is sufficiently flexible to make good surface contact with the insulation on an armature bar. The plate is electrically connected to a capacitance meter that is also coupled to ground as are the armature bars during testing. The bladder is initially deflated to reduce the thickness of the test device so that the device can be slid into the narrow gap between the insulated armature bars of a stator. Once positioned between the bars, the bladder is inflated with a pressure hose to press the electrode plate firmly against the surface of the insulation of the armature bar. Once the capacitance of the insulation has been measured, the bladder is deflated with the aid of a vacuum pump to minimize the width of the probe.

There is a need for new robotics systems that can deliver a robotic probe to a required area within a complex system, e.g. an electrical motor, to perform a test or repair and if required to move a probe or tool within a confined space to effect that test or repair, without damaging other components of the system, e.g. rotors, stators, windings or contacts or wires within the system. In other words, new designs for robotics need to be developed to overcome the limitations of conventional tools for testing and repairing machinery.

### SUMMARY

In a first aspect there is provided an inflatable probe as set out in claim 1.

In some embodiments a second seal electrode are provided around the external surface of the balloon and the sealing plug, so as to seal the balloon against the sealing plug, and the second seal electrode is provided with an electrical contact to connect to the outer electrode.

In some embodiments each inner electrode and each outer electrode are flexible electrodes.

In some embodiments each internal electrode is formed of at least one of graphene, carbon nanotubes, and metallic nanotubes.

In some embodiments there may be from 2 to 12 pairs of inner electrodes and outer electrodes.

In some embodiments there are a plurality of parallel arranged inflatable balloons each with separate pairs of inner electrodes and outer electrodes to enable positioning of the sensor relative to the component of interest.

In some embodiments the at least one tool is one or more of a charge-coupled device, a complementary metal-oxide semiconductor chip, a Hall effect sensor, and a grabbing implement.

In some embodiments the first wire that is connected to the first seal electrode and a second wire that is connected to the second seal electrode are coupled to control voltage sources to provide a controlled supply of voltage to the at least one electrode pair.

In some embodiments a voltage supply is connected to a computer to control the supply of voltage to the at least one electrode pair, the computer also being used to receive signals from the inflatable probe.

In some embodiments a conduit is provided in the sealing plug for supplying fluid and removing fluid from the balloon.

In a second aspect there is provided a method of testing a component using the inflatable probe of the first aspect as set out in claim 11.

In some embodiments the inflatable probe is moved by applying controlled voltages to the electrodes of the balloon.

In some embodiments the inflatable probe is moved to different locations with respect to the component for further testing or to a different component of interest for testing before the inflatable probe is removed from the workspace.

In some embodiments the workspace is an engine.

### BRIEF DESCRIPTION OF THE DRAWINGS

Embodiments will now be described by way of example only, with reference to the Figures, in which:
**FIG. 1a** is a schematic perspective view of a first embodiment of an inflatable probe of the present invention;
**FIG. 1b** is a schematic cut-away perspective view of the inflatable probe of FIG.1a;
**FIG. 1c** is a schematic close-up sectional view of a portion of the probe of FIGS. 1a and 1b to show the electrode structure;
**FIG. 2a** is a schematic close-up perspective view of the electrode structure of the inflatable probe shown in FIGS. 1a, 1b and 1c;
**FIG. 2b** is close-up schematic side view of the electrode structure of the inflatable probe shown in FIGS. 1a, 1b and 1c;
**FIG. 3** is a schematic perspective view of a second embodiment of an inflatable probe of the present invention that has a plurality of electrode pairs distributed about the balloon structure of the probe;
**FIG. 4** is a flow chart of a method of testing a component using an inflatable probe of the present invention.

The following table lists the reference numerals/signs used in the drawings with the features to which they refer:

| Ref no. | Feature | Figure |
|---|---|---|
| 10 | Inflatable probe | 1a 1b 2a |
| 11 | Inner electrode | 1a 1b 1c |
| 12 | Outer electrode | 1a 1b 1c |
| 13 | Balloon | 1a 1b 1c 2a 2b |
| 14 | Sealing plug | 1a 1b 2a 2b |
| 15 | First seal electrode | 1a 1b 2a 2b |
| 15a | First wire | 1a 1b 2a 2b |
| 16 | Second seal electrode (e.g. clip) | 1a 2a 2b |
| 16a | Second wire | 1a 2a 2b |
| 18 | Neck | 1a 1b 2a |
| 19 | Tool (e.g. CCD) | 1a 3 |
| 20 | Inflatable probe | 3 |
| 21 | Outer electrode | 3 |
| 22 | Non-conducting area | 3 |
| 23 | Balloon | 3 |
| 24 | Sealing plug | 3 |
| 25 | First seal electrode | 3 |
| 29 | Tool (e.g. CMOS chip) | 3 |
| 30 | Method | 4 |
| 31 | Step | 4 |
| 32 | Step | 4 |
| 33 | Step | 4 |
| 34 | Step | 4 |

### DETAILED DESCRIPTION

Aspects and embodiments of the present invention will now be discussed with reference to the accompanying figures. Further aspects and embodiments will be apparent to those skilled in the art.

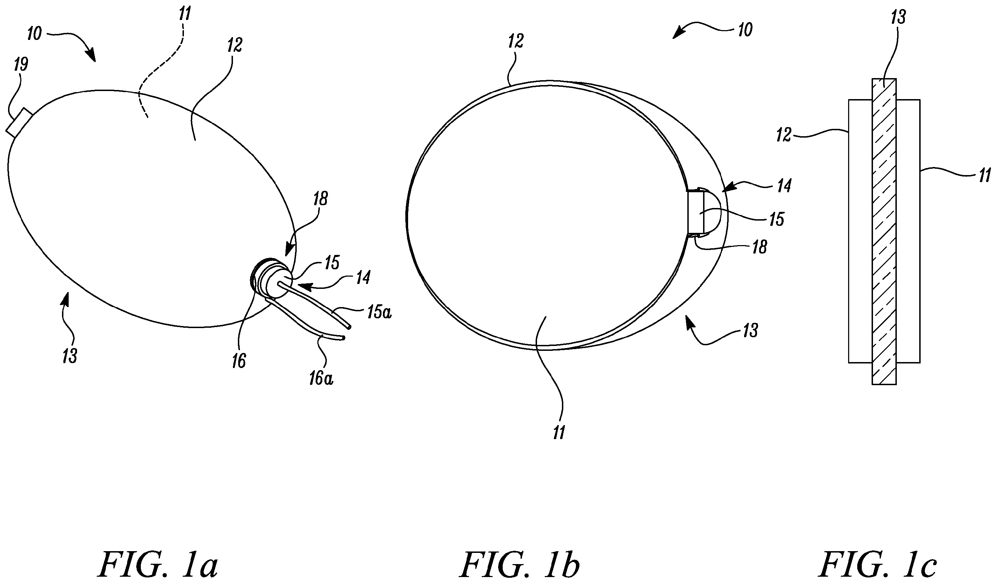

FIG. 1a is a schematic perspective view of a first embodiment of an inflatable probe of the present invention in the form of a dielectric elastomer balloon. In this a balloon 13 is provided (e.g. coated) with a compliant inner electrode (11) and an outer electrode 12. The inner electrode is positioned on the inside surface of the balloon 13, whilst the outer electrode 12 is positioned on the outside of the balloon 13. In FIG. 1a the balloon 13 is in an inflated state and contains a fluid e.g. a liquid or air. The fluid is sealed in the balloon using a sealing plug 14 that is position in a neck 18 of the probe. The sealing plug 14 provides a first seal electrode 15, which is used to engage with the inner electrode within the balloon 13, and has a wire 15a that is connected to the first seal electrode and passes through the sealing plug 14 . The sealing plug 14 also has a second seal electrode 16 that is positioned around the outside of the sealing plug 14. In FIG. 1 the second seal electrode 16 in the form of a clip that forms around the balloon 13. The clip, which may be made of any suitable material, acts both as the second seal electrode for connecting with the outer electrode 12 on the surface of the balloon 13 and a clamp to hold the balloon 13 onto the sealing plug 14. FIG. 1a shows a wire 16a leading from the clip 16. The wire 16a is used to provide a voltage to the second seal electrode 16 and thus to the outer electrode 12 on the balloon. The balloon 13 itself is formed of a dielectric material, which may for example a rubber or latex or other deformable dielectric material. The inflatable probe has a tool 19 located on the balloon opposite the neck 18. There may be any suitable number of tools 19 positioned about the balloon 23. The tool 19 may be any suitable inspection tool or sensing device. For example the tool 19 may be a charge-coupled device (CCD) or complementary metal-oxide semiconductor (CMOS) chip for component inspection including non-destructive evaluation, or a Hall effect sensor for assessing magnetic field quality, or a grabbing implement for removal of foreign object damage. In FIG. 1a the tool 19 is a charge-coupled device (CCD) housed in a sensor head for digitally imaging components for non-destructive evaluation

**FIG. 1b** is a schematic cut-away image of the inflatable probe shown in FIG. 1a. FIG. 1b shows the inner electrode 11 of the inflatable probe 10 that is provided (e.g. coated) on the inside surface of the balloon 13 with the outer electrode 12 being provided on the outside surface of the balloon 13. The sealing plug 14 is also shown in the neck 18 of the balloon 13. The sealing plug 14 forms an airtight seal with the deformable dielectric material of the balloon 13. The first seal electrode is used to supply the voltage to the inner electrode 11 on the inner surface of the balloon 13 whilst the second seal electrode 16 provides the voltage to the outer electrode 12 on the outer surface of the balloon.

**FIG. 1c** is a schematic close-up view of the electrode structure of the probe of FIGS. 1a and 1b. The balloon 13 is formed of a deformable dielectric material, e.g. a latex. Coating the outer/external surface of the balloon 13 is the outer electrode 12. Coating the inner/internal surface of the balloon 13 is the inner electrode 11. As the balloon 13 is formed of a deformable dielectric material, it will stretch or decrease in size depending upon whether the balloon is inflated or deflated and the electrodes must also be able to stretch and deform with the dielectric material that they are formed around. If the inner electrode 11 and the outer electrode 12 are not able to deform they may well damage or break the balloon 13.

The electrodes may be made from any suitable deformable conducting material. In particular, this may a flexible host or matrix doped with materials such as graphene, carbon nanotubes, metallic nanotubes. Such coatings may be applied as a spray with a spray gun and then heated to cure. If the electrode and dielectric material are both made of a rubber, the adhesion between them and the rubber/latex balloon will be strong. Alternatively, it may be made from another suitable conductive polymer coated onto the inner or the outer surface of the balloon 13. Alternatively, it may be made of any other deformable electrode. The use of electrodes about a layer of flexible dielectric material means that this area of the balloon acts as an actuator. As such, the application of a voltage to the electrodes creates a pressure within the layer of flexible dielectric material and results in deformation of the shape of that layer. This deformation causes an extension/inflation or compression/deflation of the balloon. By attuning the electrode structure around the dielectric elastomer balloon allows for controlled deformation such that the actuator can be manipulated in shape.

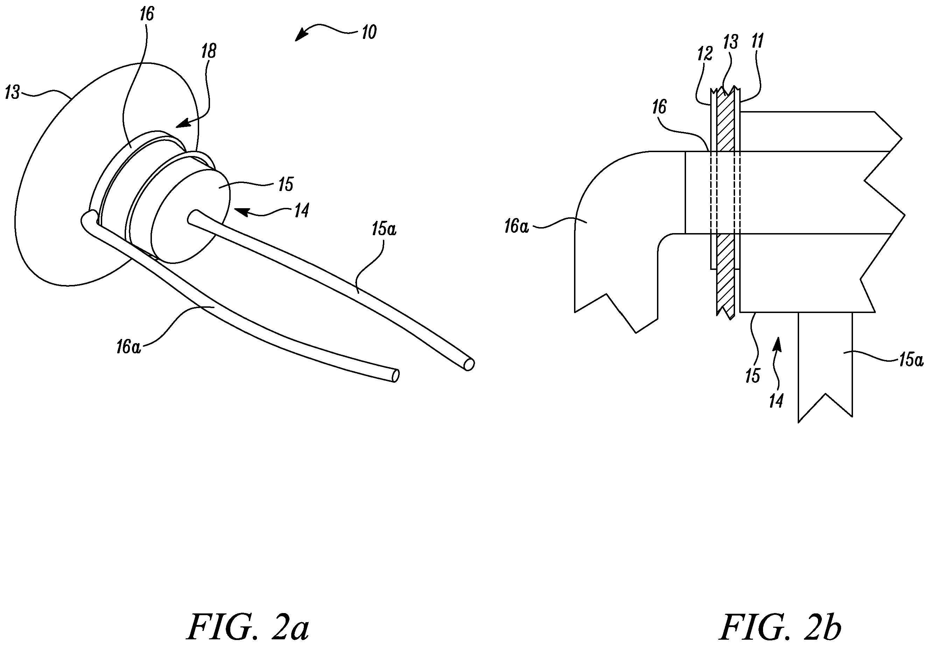

**FIG. 2a** is a schematic close-up perspective view of the electrode structure of the inflatable probe 10 shown in FIGS. 1a, 1b and 1c, more particularly the portion on and around the sealing plug 14 of the probe. The sealing plug 14 is used to maintain the volume of fluid within the balloon 13. The fluid may be a gas such as air, nitrogen, or a gas lighter than air such as helium. The sealing plug 14, which includes the first seal electrode 15, may be made from a solid material, e.g. a metal. The second seal electrode 16 may be provided on the sealing plug 14. Alternatively, as presented in FIG. 2a the second seal electrode 16 may be formed on a clip that also has a purpose to keep the balloon 13 attached to the sealing plug 14. The clip may be formed of any suitable material, e.g. a metal, a plastics material or a composite material. The second seal electrode 16 for contacting the outer electrode 12 on the balloon 13 is typically made from a solid material, e.g. a metal such as copper, which may be a copper strip. The advantage of using solid materials for the electrodes is that it allows for wire cables to be used, these can be easily connected to the electrodes. It also allows for easier connection with the balloon 13 that has a low surface energy.

**FIG. 2b** presents a close-up of the electrical connections within the inflatable probe 10. In FIG. 2b the balloon 13 is shown with the inner electrode 21 mounted on the inner surface of the balloon 13 and the outer electrode 22 mounted on the outer surface of the balloon 13. The sealing plug 14 with the first seal electrode 15 is shown abutting the inner electrode 11 of the balloon 13. The clip containing the second seal electrode 16 is shown contacting the outer electrode 12. In FIG. 2b the first wire 15a and the second wire 17 are shown to connect with the first seal electrode 15 and the second seal electrode 22 respectively. In this embodiment the first wire 15a is the negative wire and the second wire 16a is the positive wire. In this case the use of the clip for the second seal electrode 16 is beneficial as it imparts a force onto the balloon 13 and maintains the contact between the first and second seal electrodes and the inner and outer electrodes that are on the balloon 13. The sealing plug 14 may also have a conduit attached that allows for the inflation and deflation of the balloon at appropriate times.

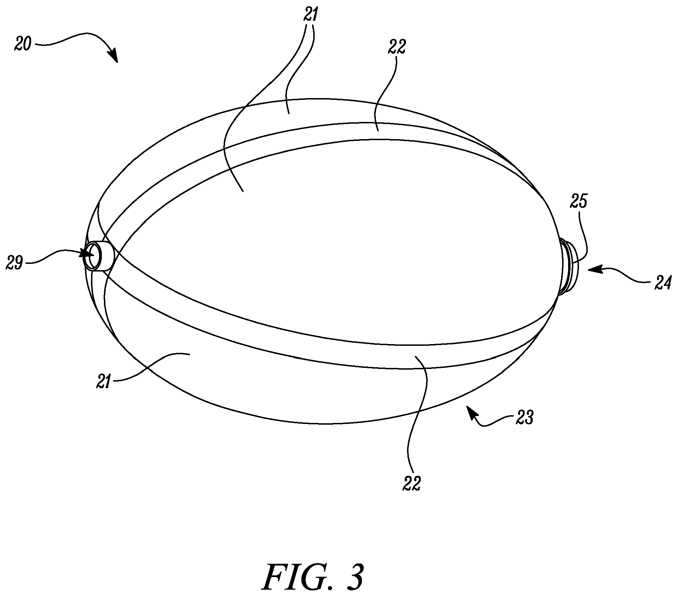

**FIG. 3** is a schematic perspective view of a second embodiment of an inflatable probe 20 of the present invention. In this embodiment the balloon 23 is shown having a plurality of outer electrodes 21 positioned around the outer/external surface of the balloon 23. Each outer electrode 21 is separated from the neighbouring outer electrode 21 by a non-conducting area 22, which area is not covered with the electrode material. The position of the inner electrodes (not shown) on the inner/internal surface of the balloon 23 corresponds with the position of the outer electrodes, i.e. they are located on the opposing surface of the balloon 23. The sealing plug 24 has a number of first seal electrodes that connect with the positions of the inner electrodes. Each of these electrodes may have their voltage supplied by its own wire. Alternatively, the electrodes may have the voltage supplied through a single wire or they may be paired up to reduce the number of wires. The number of second seal electrodes on the sealing system, whether on the plug, clip or other sealing mechanism will be the same as the number of outer electrodes 21. Each of these are solid electrodes which pair with the outer electrodes. Similar to the first seal electrodes the second seal electrodes may be supplied by any suitable number of wires from a single wire, electrodes matched in groups to each electrode having its own wire. At the head of the probe is shown a tool 29. In FIG. 3 the tool 29 is a complementary metal-oxide semiconductor (CMOS) chip housed in a sensor head for digitally imaging components for non-destructive evaluation. There may be any suitable number of tools 29 positioned about the balloon 23. The tool 29 may be any suitable inspection tool or sensing device. For example the tool 19 may be a charge-coupled device (CCD) or complementary metal-oxide semiconductor (CMOS) chip for component inspection including non-destructive evaluation, or a Hall effect sensor for assessing magnetic field quality, or a grabbing implement for removal of foreign object damage. The response from the tool at the tip of the inflatable probe may be transmitted via electrical wires, optical fibres, or wireless methods such as Bluetooth^{®} or Wi-Fi^{™} to the outside of the complex component under investigation.

By controlling the voltage to the electrodes, which are separated by the dielectric medium of the balloon, causes a deformation of the balloon about the electrode. The deformation of the balloon is a result of the forces acting upon it. When voltage is applied to the electrodes, an electric field is established within the thin dielectric layer of the balloon. The electric field causes Compressive Maxwell stress within the dielectric material of the balloon. This causes a reduction in the thickness of the dielectric material but an increase in the area of the dielectric material. Therefore, through the application of voltage it is possible to control the deformation of the balloon probe and thus allow it to move. By using a number of electrodes around the probe, the probe is able to move with a number of degrees of freedom. The balloon probe works by controlling the voltage to the electrodes so that the probe is able to move within a confined space to a point to sense or probe the system. In the case of a single electrode pair the balloon probe can crawl through the space, with more than one electrode pair the balloon can walk by expanding one electrode area whilst maintaining the other at the same length and repeating for the other electrode pair. The greater the number of electrode pairs and the more control that the system can have. However, the increase in the number of electrode pairs also increases the complexity of the system.

The probe can be inserted into the component to be inspected in an inflated or non-inflated state depending upon the size of the aperture. Once into a space the pressure within the balloon may be controlled by the addition or removal of a fluid. This allows the probe to either be able to slide through a gap with minimal contact with the walls or to crawl into a space if the balloon cannot be slid into the appropriate position. If the balloon is slid into position the balloon may be inflated so that contact with the component is maintained and inspection using the probe can take place. Although, this is described as slid, it may also apply to be floated into position if the fluid used is lighter than air. Changing the fluid as the balloon probe moves within the complex environment can assist the balloon to move through more complex environments.

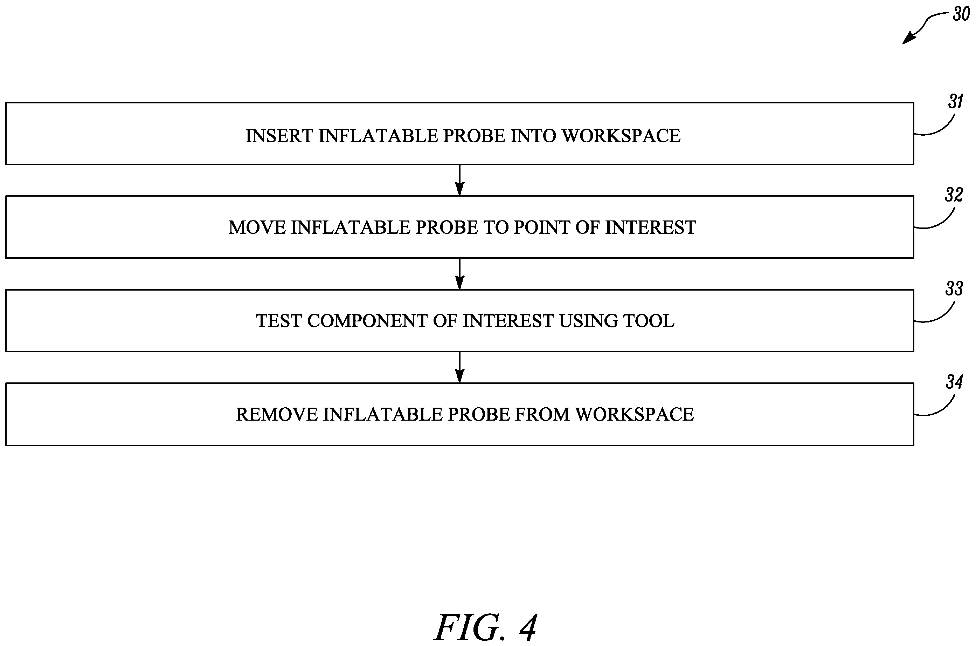

FIG. 4 presents a flow chart at the operation of the probe of the present invention in a method 30 of testing a component . In Step 31 the device is inserted into the working space. Access to the workspace may be through an access port, like a borescope port or similar, or the casing of the complex component may be removed or if there is small external access then the probe may be inserted through that access. With the probe inside the complex component the probe can be moved and positioned to a point that is of interest in Step 32. The number of electrode pairs on the balloon will determine in which planes it is possible to move the probe. In the case of a single electrode pair the probe will only be able to move in a single plane. If there are more electrode pairs then the number of planes that the balloon can move in increases so that it can access more difficult to reach regions of the component. The pressure in the balloon may be changed during the positioning step. This allows the balloon to move more easily and to reach narrower and more difficult to reach parts that are not accessible by other means. In Step 33 the testing using the sensor takes place. The testing may be to inspect for degradation of components or inclusion of foreign object debris in the electrical machine, or to non-visually assess the health of the asset such as through a Hall effect sensor to study the magnetic field quality. Depending upon the nature of the tests the balloon may be inflated to fill the cavity/volume that is being inspected. Inflation of the balloon may help to position the sensor against the size of the component within the cavity/volume. Once the testing has been performed the balloon may be moved to a second location. This may be done by moving the device using any cables. Alternatively, controlled voltage may be applied to the inner and outer electrodes on the balloon. By applying the controlled voltage allows the balloon to move itself within the space by crawling its way along at least one of the surfaces of the cavity/volume. Once the balloon is moved into the second or further desired location the sensor may perform more tests to build up a map or an image of the desired properties of the scan area of the component. Once the desired number of tests have been performed within the desired area of the component the balloon probe can be removed from the component - Step 34. Depending upon the nature of the area that has been probed the balloon may be inflated or deflated as appropriate and the electrodes activated if required so that the probe is able to crawl out of the area and then removed through the insertion hole.

The system may also comprise more than one balloons covered with their electrodes arranged within the system. The balloons may be arranged in parallel. The plurality of balloons may be as described above. Each balloon may have its own sealing plug or may have a single plug. The electrode pairs on the balloons may be able coupled or may each be individually addressable. The presence of a plurality of linked balloons, allows for the structure to move in a controlled way.

## Claims

1. An inflatable probe (10, 20) for testing a component, the inflatable probe comprising:
a balloon (13, 23) formed of a dielectric material, the balloon having a neck (18) and at least one electrode pair comprising an inner electrode (11) and an outer electrode (12), the inner electrode (11) being positioned on an internal surface of the balloon (13, 23) and the outer electrode (12) being positioned on an external surface of the balloon (13, 23);
a sealing plug (14, 24) that forms an air tight seal with the neck (18) of the balloon (13, 23) to retain a fluid within the balloon, the sealing plug (14, 24) at least having a seal electrode (15) to connect to the inner electrode (11) within the balloon, the sealing plug supporting a first wire (15a) to connect to the first seal electrode (15); and
at least one tool (19, 29) that is connected to the balloon (13, 23).

2. The inflatable probe of claim 1, wherein a second seal electrode (16) is provided around the external surface of the balloon (13, 23) and the sealing plug (14), so as to seal the balloon against the sealing plug, and the second seal electrode is provided with an electrical contact to connect to the outer electrode (12).

3. The inflatable probe of claim 1 or 2, wherein each inner electrode (11) and each outer electrode (12) are flexible electrodes.

4. The inflatable probe of claim 3, wherein each inner electrode (11) is formed of at least one of graphene, carbon nanotubes, and metallic nanotubes.

5. The inflatable probe of any preceding claim, wherein there are from 2 to 12 pairs of inner electrodes (11) and outer electrodes (12).

6. The inflatable probe of claim 5, wherein there are a plurality of parallel arranged inflatable balloons (13, 23) each with separate pairs of inner electrodes (11) and outer electrodes (12) to enable positioning of the tool (19, 29) with respect to the component.

7. The inflatable probe of any preceding claim, wherein the at least one tool (19, 29) is one or more of a charge-coupled device, a complementary metal-oxide semiconductor chip, a Hall effect sensor, and a grabbing implement.

8. The inflatable probe of any one of claims 2 to 7, wherein the first wire (15a) that is connected to the first seal electrode (15) and a second wire (16a) that is connected to the second seal electrode (16) are coupled to control voltage sources to provide a controlled supply of voltage to the at least one electrode pair (11, 12).

9. The inflatable probe of claim 8, wherein a voltage supply is connected to a computer to control the supply of voltage to the at least one electrode pair (11, 12), the computer also being used to receive signals from the inflatable probe.

10. The inflatable probe of any preceding claim, wherein a conduit is provided in the sealing plug (14, 24) for supplying fluid and removing fluid from the balloon (13, 23).

11. A method of testing a component using the inflatable probe (10, 20) of any preceding claim, the method comprising the steps of:
inserting the inflatable probe (10, 20) of any preceding claim into a workspace;
moving the inflatable probe (10, 20) within the workspace to a component of interest for testing;
testing the component using the at least one tool (19, 29) of the inflatable probe (10, 20); and
removing the inflatable probe (10, 20) away from the component and out of the workspace.

12. The method of claim 11, wherein the inflatable probe (10, 20) is moved by applying controlled voltages to the electrodes (11, 12, 21) of the balloon (13, 23).

13. The method of claim 11 or 12, wherein the inflatable probe (10, 20) is moved to different locations with respect to the component for further testing or to a different component of interest for testing before the inflatable probe is removed from the workspace.

14. The method of any one of claims 11 to 13, where the workspace is an engine.

## Patentansprüche

1. Aufblasbare Sonde (10, 20) zum Testen einer Komponente, wobei die aufblasbare Sonde Folgendes umfasst:
einen Ballon (13, 23), der aus einem dielektrischen Material gebildet ist, wobei der Ballon einen Hals (18) und zumindest ein Elektrodenpaar aufweist, das eine innere Elektrode (11) und eine äußere Elektrode (12) umfasst, wobei die innere Elektrode (11) auf einer internen Oberfläche des Ballons (13, 23) positioniert ist und die äußere Elektrode (12) auf einer externen Oberfläche des Ballons (13, 23) positioniert ist;
einen Dichtungsstopfen (14, 24), der eine luftdichte Dichtung mit dem Hals (18) des Ballons (13, 23) bildet, um ein Fluid innerhalb des Ballons zu halten, wobei der Dichtungsstopfen (14, 24) zumindest eine Dichtungselektrode (15) zum Verbinden mit der inneren Elektrode (11) innerhalb des Ballons aufweist, wobei der Dichtungsstopfen einen ersten Draht (15a) zum Verbinden mit der ersten Dichtungselektrode (15) stützt; und
zumindest ein Werkzeug (19, 29), das mit dem Ballon (13, 23) verbunden ist.

2. Aufblasbare Sonde nach Anspruch 1, wobei eine zweite Dichtungselektrode (16) um die externe Oberfläche des Ballons (13, 23) und den Dichtungsstopfen (14) bereitgestellt ist, um den Ballon gegen den Dichtungsstopfen abzudichten, und die zweite Dichtungselektrode mit einem elektrischen Kontakt zum Verbinden mit der äußeren Elektrode (12) bereitgestellt ist.

3. Aufblasbare Sonde nach Anspruch 1 oder 2, wobei jede innere Elektrode (11) und jede äußere Elektrode (12) flexible Elektroden sind.

4. Aufblasbare Sonde nach Anspruch 3, wobei jede innere Elektrode (11) aus zumindest einem von Graphen, Kohlenstoffnanoröhren und metallischen Nanoröhren gebildet ist.

5. Aufblasbare Sonde nach einem vorhergehenden Anspruch, wobei es 2 bis 12 Paare von inneren Elektroden (11) und äußeren Elektroden (12) gibt.

6. Aufblasbare Sonde nach Anspruch 5, wobei es eine Vielzahl von parallel angeordneten aufblasbaren Ballons (13, 23) jeweils mit separaten Paaren von inneren Elektroden (11) und äußeren Elektroden (12) gibt, um Positionierung des Werkzeugs (19, 29) in Bezug auf die Komponente zu ermöglichen.

7. Aufblasbare Sonde nach einem vorhergehenden Anspruch, wobei das zumindest eine Werkzeug (19, 29) eines oder mehrere von einer ladungsgekoppelten Vorrichtung, einem komplementären Metalloxidhalbleiterchip, einem Hall-Effekt-Sensor und einem Greifgerät ist.

8. Aufblasbare Sonde nach einem der Ansprüche 2 bis 7, wobei der erste Draht (15a), der mit der ersten Dichtungselektrode (15) verbunden ist, und ein zweiter Draht (16a), der mit der zweiten Dichtungselektrode (16) verbunden ist, an Steuerspannungsquellen gekoppelt sind, um eine gesteuerte Zufuhr von Spannung an das zumindest eine Elektrodenpaar (11, 12) bereitzustellen.

9. Aufblasbare Sonde nach Anspruch 8, wobei eine Spannungszufuhr mit einem Computer verbunden ist, um die Zufuhr von Spannung an das zumindest eine Elektrodenpaar (11, 12) zu steuern, wobei der Computer auch verwendet wird, um Signale von der aufblasbaren Sonde zu empfangen.

10. Aufblasbare Sonde nach einem vorhergehenden Anspruch, wobei eine Leitung in dem Dichtungsstopfen (14, 24) zum Zuführen von Fluid und Entfernen von Fluid aus dem Ballon (13, 23) bereitgestellt ist.

11. Verfahren zum Testen einer Komponente unter Verwendung der aufblasbaren Sonde (10, 20) nach einem vorhergehenden Anspruch, wobei das Verfahren die folgenden Schritte umfasst:
Einsetzen der aufblasbaren Sonde (10, 20) nach einem vorhergehenden Anspruch in einen Arbeitsbereich;
Bewegen der aufblasbaren Sonde (10, 20) innerhalb des Arbeitsbereichs zu einer Komponente von Interesse zum Testen;
Testen der Komponente unter Verwendung des zumindest einen Werkzeugs (19, 29) der aufblasbaren Sonde (10, 20); und
Entfernen der aufblasbaren Sonde (10, 20) weg von der Komponente und aus dem Arbeitsbereich.

12. Verfahren nach Anspruch 11, wobei die aufblasbare Sonde (10, 20) durch Anlegen von gesteuerten Spannungen an die Elektroden (11, 12, 21) des Ballons (13, 23) bewegt wird.

13. Verfahren nach Anspruch 11 oder 12, wobei die aufblasbare Sonde (10, 20) zu verschiedenen Stellen in Bezug auf die Komponente zum weiteren Testen oder zu einer anderen Komponente von Interesse zum Testen bewegt wird, bevor die aufblasbare Sonde von dem Arbeitsbereich entfernt wird.

14. Verfahren nach einem der Ansprüche 11 bis 13, wobei der Arbeitsbereich ein Triebwerk ist.

## Revendications

1. Sonde gonflable (10, 20) destiné à la réalisation d'essais sur un composant, la sonde gonflable comprenant : un ballonnet (13, 23) formé d'un matériau diélectrique, le ballonnet comportant un col (18) et au moins une paire d'électrodes comprenant une électrode interne (11) et une électrode externe (12), l'électrode interne (11) étant positionnée sur une surface interne du ballonnet (13, 23) et l'électrode externe (12) étant positionnée sur une surface externe du ballonnet (13, 23) ;
un bouchon d'étanchéité (14, 24) qui forme un joint hermétique avec le col (18) du ballonnet (13, 23) pour retenir un fluide à l'intérieur du ballonnet, le bouchon d'étanchéité (14, 24) comportant au moins une électrode (15) de joint d'étanchéité pour se connecter à l'électrode interne (11) à l'intérieur du ballonnet, le bouchon d'étanchéité supportant un premier fil (15a) pour se connecter à la première électrode (15) de joint d'étanchéité ; et
au moins un outil (19, 29) qui est connecté au ballonnet (13, 23).

2. Sonde gonflable de la revendication 1, une seconde électrode (16) de joint d'étanchéité étant prévue autour de la surface externe du ballonnet (13, 23) et du bouchon d'étanchéité (14), de façon à assurer l'étanchéité du ballonnet contre le bouchon d'étanchéité, et ladite seconde électrode de joint d'étanchéité étant pourvue d'un contact électrique pour se connecter à l'électrode externe (12).

3. Sonde gonflable de la revendication 1 ou 2, chaque électrode interne (11) et chaque électrode externe (12) étant des électrodes flexibles.

4. Sonde gonflable de la revendication 3, chaque électrode interne (11) étant formée d'au moins l'un du graphène, des nanotubes de carbone et des nanotubes métalliques.

5. Sonde gonflable d'une quelconque revendication précédente, comportant de 2 à 12 paires d'électrodes internes (11) et d'électrodes externes (12).

6. Sonde gonflable de la revendication 5, une pluralité de ballonnets gonflables (13, 23) étant agencés parallèlement, chacun avec des paires séparées d'électrodes internes (11) et d'électrodes externes (12) pour permettre le positionnement de l'outil (19, 29) par rapport au composant.

7. Sonde gonflable d'une quelconque revendication précédente, ledit au moins un outil (19, 29) étant l'un ou plusieurs d'un dispositif à couplage de charge, d'une puce à structure métal-oxyde-semiconducteur complémentaire, d'un capteur à effet Hall et d'un instrument de préhension.

8. Sonde gonflable de l'une quelconque des revendications 2 à 7, ledit premier fil (15a) qui est connecté à la première électrode (15) de joint d'étanchéité et un second fil (16a) qui est connecté à la seconde électrode (16) de joint d'étanchéité étant couplés à des sources de tension de commande pour fournir une alimentation commandée en tension à ladite au moins une paire d'électrodes (11, 12).

9. Sonde gonflable de la revendication 8, une alimentation en tension étant connectée à un ordinateur pour commander l'alimentation en tension de l'au moins une paire d'électrodes (11, 12), l'ordinateur étant également utilisé pour recevoir des signaux en provenance de la sonde gonflable.

10. Sonde gonflable d'une quelconque revendication précédente, un conduit étant prévu dans le bouchon d'étanchéité (14, 24) pour l'alimentation en fluide et le retrait de fluide du ballonnet (13, 23).

11. Procédé de réalisation d'essai d'un composant à l'aide de la sonde gonflable (10, 20) d'une quelconque revendication précédente, le procédé comprenant les étapes de :
insertion de la sonde gonflable (10, 20) d'une quelconque revendication précédente dans un espace de travail ;
déplacement de la sonde gonflable (10, 20) à l'intérieur de l'espace de travail vers un composant d'intérêt pour la réalisation d'essais ;
réalisation d'essais du composant à l'aide dudit au moins un outil (19, 29) de la sonde gonflable (10, 20) ; et
retrait de la sonde gonflable (10, 20) du composant et hors de l'espace de travail.

12. Procédé de la revendication 11, ladite sonde gonflable (10, 20) étant déplacée en appliquant des tensions commandées aux électrodes (11, 12, 21) du ballonnet (13, 23).

13. Procédé de la revendication 11 ou 12, ladite sonde gonflable (10, 20) étant déplacée vers différents emplacements par rapport au composant pour la réalisation d'essais supplémentaires ou vers un composant d'intérêt différent pour la réalisation d'essais avant que la sonde gonflable ne soit retirée de l'espace de travail.

14. Procédé de l'une quelconque des revendications 11 à 13, ledit espace de travail étant un moteur.
